(19) Europäisches Patentamt
European Patent Office
Office européen des brevets

(11) **EP 4 383 312 A1**

(12) **EUROPEAN PATENT APPLICATION**
published in accordance with Art. 153(4) EPC

(43) Date of publication:
**12.06.2024 Bulletin 2024/24**

(21) Application number: **22864563.6**

(22) Date of filing: **30.08.2022**

(51) International Patent Classification (IPC):
**H01L 21/02** (2006.01)     **H01L 21/56** (2006.01)

(52) Cooperative Patent Classification (CPC):
**H01L 21/02; H01L 21/56**

(86) International application number:
**PCT/JP2022/032589**

(87) International publication number:
**WO 2023/032981 (09.03.2023 Gazette 2023/10)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **03.09.2021 PCT/JP2021/032480**

(71) Applicant: **Resonac Corporation
Tokyo 105-7325 (JP)**

(72) Inventors:
• **AKASU, Yuta
Minato-ku, Tokyo 105-7325 (JP)**
• **MIYAZAWA, Emi
Minato-ku, Tokyo 105-7325 (JP)**
• **ENOMOTO, Tetsuya
Minato-ku, Tokyo 105-7325 (JP)**

(74) Representative: **Berggren Oy
P.O. Box 16
Eteläinen Rautatiekatu 10A
00101 Helsinki (FI)**

(54) **FILM FOR TEMPORARY FIXATION, LAYERED PRODUCT FOR TEMPORARY FIXATION, AND METHOD FOR PRODUCING SEMICONDUCTOR DEVICE**

(57)     A film for temporary fixing used for temporarily fixing a semiconductor member and a support member is disclosed. This film for temporary fixing contains carbon black and a curable resin component. The curable resin component contains a thermosetting resin and a thermoplastic resin. The thermoplastic resin is a hydrocarbon resin. In this film for temporary fixing, a content of the carbon black satisfies at least one condition of the following Condition (i) and Condition (ii):

Condition (i): the content of the carbon black is 0.1 to 25 parts by mass with respect to the total amount of 100 parts by mass of the curable resin component; and

Condition (ii): the content of the carbon black is 0.1 to 10% by volume based on the total volume of the film for temporary fixing.

*Fig.1*

EP 4 383 312 A1

**Description**

**Technical Field**

The present disclosure relates to a film for temporary fixing, a laminated body for temporary fixing, and a method for producing a semiconductor device.

**Background Art**

Semiconductor devices may be produced by a method in which a semiconductor member is processed in a state of being temporarily fixed to a support member, and then the semiconductor member is separated from the support member. For example, Patent Literature 1 discloses a method of temporarily fixing a semiconductor member to a support member, with a temporary fixing material layer interposed therebetween, and separating the semiconductor member from the support member by light irradiation after a processing treatment.

**Citation List**

**Patent Literature**

Patent Literature 1: WO 2020/111193 A1

**Summary of Invention**

**Technical Problem**

From the viewpoint of a processing treatment, it is necessary to firmly fix the semiconductor member to the support member with the temporary fixing material layer interposed therebetween. However, in the case of producing a semiconductor device by a method including separating the semiconductor member from the temporary fixing material layer by light irradiation, when adhesiveness for temporarily fixing the semiconductor member of the temporary fixing material layer to the support member is improved, at the time of separating the semiconductor member from the support member by light irradiation, there is a case where the semiconductor member cannot be separated from the support member even in the case of applying external force. Therefore, the temporary fixing material layer is also required to have excellent separability by light irradiation at the time of separating the semiconductor member from the support member.

In this regard, a main object of the present disclosure is to provide a film for temporary fixing capable of forming a temporary fixing material layer excellent in adhesiveness between the semiconductor member and the support member and also excellent in separability at the time of separating the semiconductor member from the support member by light irradiation in the case of producing a semiconductor device by a method including separating the semiconductor member from the temporary fixing material layer by light irradiation.

**Solution to Problem**

One aspect of the present disclosure relates to a film for temporary fixing. This film for temporary fixing is used for temporarily fixing a semiconductor member and a support member. This film for temporary fixing contains carbon black and a curable resin component. The curable resin component contains a thermosetting resin and a thermoplastic resin. The thermoplastic resin is a hydrocarbon resin. In this film for temporary fixing, a content of the carbon black satisfies at least one condition of the following Condition (i) and Condition (ii):

Condition (i): the content of the carbon black is 0.1 to 25 parts by mass with respect to the total amount of 100 parts by mass of the curable resin component; and
Condition (ii): the content of the carbon black is 0.1 to 10% by volume based on the total volume of the film for temporary fixing.

When the content of the carbon black satisfies at least one of conditions: the content thereof is 0.1 parts by mass or more with respect to the total amount of 100 parts by mass of the curable resin component and the content thereof is 0.1% by volume or more based on the total volume of the film for temporary fixing, there is a tendency that a film for temporary fixing to be obtained is excellent in separability at the time of separating the semiconductor member from the support member by light irradiation. On the other hand, when the content of the carbon black satisfies at least one of conditions: the content thereof is 25 parts by mass or less with respect to the total amount of 100 parts by mass of the curable resin component and the content thereof is 10% by volume or less based on the total volume of the film for temporary fixing, there is a tendency that a film for temporary fixing to be obtained is excellent in adhesiveness between the support member and the semiconductor member.

According to such a film for temporary fixing, it becomes possible to form a temporary fixing material layer excellent in adhesiveness between the support member and the semiconductor member and also excellent in separability at the time of separating the semiconductor member from the support member by light irradiation, in the case of producing a semiconductor device by a method including separating the semiconductor member from the temporary fixing material layer by light irradiation.

In the film for temporary fixing, a parallel light transmittance at at least one wavelength of a wavelength of 550 nm and a wavelength of 1064 nm may be 30% or less.

A thickness of the film for temporary fixing may be more than 5 μm.

One aspect of the present disclosure relates to a laminated body for temporary fixing. An embodiment of this laminated body for temporary fixing includes a support member and a temporary fixing material layer formed from the above-described film for temporary fixing, the temporary fixing material layer provided on the support member.

Another embodiment of this laminated body for temporary fixing includes a support member, a first curable resin layer formed from a first curable resin film, and a temporary fixing material layer formed from the above-described film for temporary fixing, in this order. Another embodiment of this laminated body for temporary fixing may further include a second curable resin layer formed from a second curable resin film, the second curable resin layer provided on a side on the temporary fixing material layer opposite to the first curable resin layer. In the first curable resin film, a parallel light transmittance at at least one wavelength of a wavelength of 550 nm and a wavelength of 1064 nm may be 80% or more.

One aspect of the present disclosure relates to a method for producing a semiconductor device. This method for producing a semiconductor device includes a step of preparing the above-described laminated body for temporary fixing, a step of temporarily fixing a semiconductor member to the support member with the temporary fixing material layer interposed therebetween, a step of processing the semiconductor member temporarily fixed to the support member, and a step of separating the semiconductor member from the support member by irradiating the temporary fixing material layer of the laminated body for temporary fixing with light from the support member side.

The light irradiated to the laminated body for temporary fixing from the support member side may be light including at least infrared light. Furthermore, the light irradiated to the laminated body for temporary fixing from the support member side may be incoherent light.

The present disclosure provides a film for temporary fixing described in [1] to [3], a laminated body for temporary fixing described in [4] to [7], and a method for producing a semiconductor device described in [8] to [10].

[1] A film for temporary fixing used for temporarily fixing a semiconductor member and a support member, containing carbon black and a curable resin component, in which the curable resin component contains a thermosetting resin and a thermoplastic resin, the thermoplastic resin is a hydrocarbon resin, and a content of the carbon black satisfies at least one condition of the following Condition (i) and Condition (ii):

Condition (i): the content of the carbon black is 0.1 to 25 parts by mass with respect to the total amount of 100 parts by mass of the curable resin component; and
Condition (ii): the content of the carbon black is 0.1 to 10% by volume based on the total volume of the film for temporary fixing.

[2] The film for temporary fixing described in [1], in which a parallel light transmittance at at least one wavelength of a wavelength of 550 nm and a wavelength of 1064 nm is 30% or less.

[3] The film for temporary fixing described in [1] or [2], in which a thickness is more than 5 μm.

[4] A laminated body for temporary fixing, including: a support member; and a temporary fixing material layer formed from the film for temporary fixing described in any one of [1] to [3], the temporary fixing material layer provided on the support member.

[5] A laminated body for temporary fixing, including: a support member; a first curable resin layer formed from a first curable resin film; and a temporary fixing material layer formed from the film for temporary fixing described in any one of [1] to [3], in this order.

[6] The laminated body for temporary fixing described in [5], further including a second curable resin layer formed from a second curable resin film, the second curable resin layer provided on a side on the temporary fixing material layer opposite to the first curable resin layer.

[7] The laminated body for temporary fixing described in [5] or [6], in which a parallel light transmittance at at least one wavelength of a wavelength of 550 nm and a wavelength of 1064 nm is 80% or more in the first curable resin film.

[8] A method for producing a semiconductor device, including: a step of preparing the laminated body for temporary fixing described in any one of [4] to [7]; a step of temporarily fixing a semiconductor member to the support member with the temporary fixing material layer interposed therebetween; a step of processing the semiconductor member temporarily fixed to the support member; and a step of separating the semiconductor member from the support member by irradiating the temporary fixing material layer of the laminated body for temporary fixing with light from the support member side.

[9] The method for producing a semiconductor device described in [8], in which the light is light including at least infrared light.

[10] The method for producing a semiconductor device described in [8] or [9], in which the light is incoherent light.

**Advantageous Effects of Invention**

According to the present disclosure, there is provided a film for temporary fixing capable of forming a temporary fixing material layer excellent in adhesiveness between the support member and the semiconductor member and also excellent in separability at the time of separating the semiconductor member from the support member by light irradiation, in the case of producing a semiconductor device by a method including separating the semiconductor member from the temporary fixing material layer by light irradiation. Furthermore, according to the present disclosure, there are provided a laminated body for temporary fixing and a method for producing a semiconductor device which use such a film for temporary fixing.

**Brief Description of Drawings**

FIG. 1 is a schematic cross-sectional view illustrating an embodiment of a film for temporary fixing.

FIGS. 2A, 2B, and 2C are schematic cross-sectional views illustrating an embodiment of a laminated body for temporary fixing.

FIGS. 3A and 3B are schematic cross-sectional views illustrating an embodiment of a method for producing a semiconductor device.

FIGS. 4A, 4B, and 4C are schematic cross-sectional views illustrating an embodiment of the method for producing a semiconductor device.

FIGS. 5A and 5B are schematic cross-sectional views illustrating an embodiment of the method for producing a semiconductor device.

**Description of Embodiments**

Hereinafter, embodiments of the present disclosure will be described with reference to the drawings as appropriate. However, the present disclosure is not limited to the following embodiments. In the following embodiments, the constituent elements (including a step or the like) are not always indispensable unless otherwise specified. The sizes of constituent elements in the respective drawings are conceptual, and the relative size relationships between the constituent elements are not restricted to those illustrated in the respective drawings.

The same applies to numerical values and ranges thereof in the present specification, and the present disclosure is not limited thereby. A numerical range expressed by using "to" in the present specification indicates a range including the numerical values before and after "to" as the minimum value and the maximum value, respectively. In a numerical range described in the present specification in a stepwise manner, an upper or lower limit value described in one numerical range may be replaced with an upper or lower limit value in the other numerical range described in a stepwise manner. Furthermore, in a numerical range described in the present specification, an upper or lower limit value of the numerical range may be replaced with a value shown in Examples.

In the present specification, (meth)acrylic acid means acrylic acid or methacrylic acid corresponding thereto. The same applies to other analogous expressions such as (meth)acrylate and (meth)acryloyl groups.

Furthermore, unless otherwise specified, materials which are exemplified below may be used alone or may be used in combination of two or more kinds thereof. In a case where a plurality of substances corresponding to each component exist in a composition, a content of each component in the composition means the total amount of the plurality of substances that exist in the composition, unless otherwise specified.

[Film for temporary fixing]

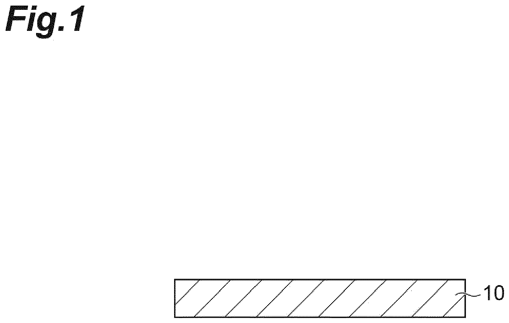

FIG. 1 is a schematic cross-sectional view illustrating an embodiment of a film for temporary fixing. A film for temporary fixing 10 illustrated in FIG. 1 is used for temporarily fixing a semiconductor member and a support member. More specifically, the film for temporary fixing 10 is used for forming a layer (temporary fixing material layer) for temporarily fixing a semiconductor member to a support member during processing of the semiconductor member in production of a semiconductor device. The film for temporary fixing 10 contains carbon black (hereinafter, sometimes referred to as "component (A)") and a curable resin component (hereinafter, sometimes referred to as "component (B)").

Component (A): carbon black

The component (A) may be a component that absorbs light and generates heat. Here, the light to be absorbed may be light including any of infrared light (near-infrared light), visible light, or ultraviolet light, may be light including any of infrared light (near-infrared light) or visible light, and may be light including at least infrared light.

Examples of the component (A) include acetylene black, Ketjen black, thermal black, channel black, and furnace black. The component (A) may be conductive carbon black having electrical conductivity, and may be, for example, acetylene black, from the viewpoint of easily absorbing light and generates heat.

The average primary particle diameter of the component (A) may be, for example, 10 to 100 nm. When the average primary particle diameter of the component (A) is 10 nm or more, there is a tendency that the dispersibility of the component (A) in the curable resin component becomes favorable. When the average primary particle diameter of the component (A) is 100 nm or less, there is a tendency that the flatness of a film for temporary fixing to be obtained becomes favorable and adhesiveness between the support member and the semiconductor member is improved. The average primary particle diameter of the component (A) may be 20 nm or more or 30 nm or more, and may be 80 nm or less or 60 nm or less. Note that, the average primary particle diameter of the component (A) can be determined by measuring the major diameters of 50 primary particles from an electron microscope image and measuring an arithmetic mean thereof.

The content of the component (A) satisfies at least one condition of the following Condition (i) and Condition (ii). The content of the component (A) may satisfy both Condition (i) and Condition (ii):

Condition (i): the content of the component (A) is 0.1 to 25 parts by mass with respect to the total amount of 100 parts by mass of the component (B); and
Condition (ii): the content of the component (A) is 0.1 to 10% by volume based on the total volume of the film for temporary fixing.

The content (% by volume) of the component (A) in Condition (ii) can be calculated, for example, from the following Formula (I) when the density of the film for temporary fixing is designated as x ($g/cm^3$), the density of the component (A) is designated as y ($g/cm^3$), and the mass proportion of the component (A) in the film for temporary fixing is designated as z (% by mass). Note that, the mass proportion of the component (A) in the film for temporary fixing can be determined, for example, by thermogravimetric analysis using a thermogravimetric differential thermal analyzer (TG-DTA).

$$\text{Content (\% by volume) of the component (A)} = (x/y) \times z \ (I)$$

When the content of the component (A) satisfies at least one of conditions: the content thereof is 0.1 parts by mass or more with respect to the total amount of 100 parts by mass of the component (B) and the content thereof is 0.1% by volume or more based on the total volume of the film for temporary fixing, there is a tendency that a film for temporary fixing to be obtained is excellent in separability at the time of separating the semiconductor member from the support member by light irradiation. In Condition (i), the content of the component (A) may be 0.3 parts by mass or more, 0.5 parts by mass or more, 0.8 parts by mass or more, 1 part by mass or more, 3 parts by mass or more, 5 parts by mass or more, or 7 parts by mass or more, with respect to the total amount of 100 parts by mass of the component (B). In Condition (ii), the content of the component (A) may be 0.2% by volume or more, 0.3% by volume or more, 0.4% by volume or more, 0.5% by volume or more, 1% by volume or more, 2% by volume or more, or 3% by volume or more, based on the total volume of the film for temporary fixing.

When the content of the component (A) satisfies at least one of conditions: the content thereof is 25 parts by mass or less with respect to the total amount of 100 parts by mass of the component (B) and the content thereof is 10% by volume or less based on the total volume of the film for temporary fixing, there is a tendency that a film for temporary fixing to be obtained is excellent in adhesiveness between the support member and the semiconductor member. In Condition (i), the content of the component (A) may be 22 parts by mass or less or 20 parts by mass or less with respect to the total amount of 100 parts by mass of the component (B). In Condition (ii), the content of the component (A) may be 9.5% by volume or less or 9% by volume or less based on the total volume of the film for temporary fixing.

Component (B): curable resin component

The component (B) may be a component that is cured by heat or light. The component (B) contains a thermoplastic resin and a thermosetting resin from the viewpoint of adhesiveness.

The thermoplastic resin is a resin having thermoplasticity, or a resin having thermoplasticity in at least an uncured state and forming a cross-linked structure after heating. The thermoplastic resin is a hydrocarbon resin.

The hydrocarbon resin is a resin whose main skeleton is composed of hydrocarbon. Examples of such a hydrocarbon resin include an ethylene-propylene copolymer, an ethylene-1-butene copolymer, an ethylene-propylene-1-butene copolymer elastomer, an ethylene-1-hexene copolymer, an ethylene-1-octene copolymer, an ethylene-styrene copolymer, an ethylene-norbornene copolymer, a propylene-1-butene copolymer, an ethylene-propylene-non-conjugated diene copolymer, an ethylene-1-butene-non-conjugated diene copolymer, an ethylene-propylene-1-butene-non-conjugated diene copolymer, polyisoprene, polybutadiene, a styrene-butadiene-styrene block copolymer (SBS), a styrene-isoprene-styrene block copolymer (SIS), a styrene-ethylene-butylene-styrene block copolymer (SEBS), and a styrene-ethylene-propylene-styrene block copolymer (SEPS). These hydrocarbon resins may be subjected to a hydrogenation treatment. Furthermore, these hydrocarbon resins may be carboxy-modified with maleic anhydride or the like. Among these, the hydrocarbon resin may include a hydrocarbon resin containing a monomer unit derived from styrene (styrene-based resin), and may include a styrene-ethylene-butylene-styrene block copolymer (SEBS).

The thermoplastic resin may include a resin other than the hydrocarbon resin as long as the effects of the present disclosure are not impaired. Examples of the resin other than the hydrocarbon resin include polycarbonate, polyphenylene sulfide, polyether sulfone, polyether imide, polyimide, a petroleum resin, and a novolac resin.

The Tg of the thermoplastic resin may be -100 to 500°C, -50 to 300°C, or -50 to 50°C. When the Tg of the thermoplastic resin is 500°C or lower, there is a tendency that flexibility is easily secured when a film-shaped temporary fixing material is formed, and low-temperature stickability can be improved. When the Tg of the thermoplastic resin is -100°C or higher, there is a tendency that deterioration of handleability and releasability caused by flexibility increasing excessively when a film-shaped temporary fixing material is formed can be suppressed.

The Tg of the thermoplastic resin is a midpoint glass transition temperature value obtained by differential scanning calorimetry (DSC). The Tg of the thermoplastic resin is specifically a midpoint glass transition temperature calculated by the method according to JIS K 7121 by measuring a change in calorific value under the conditions of a temperature increasing rate of 10°C/min and a measurement temperature of -80 to 80°C.

The weight average molecular weight (Mw) of the thermoplastic resin may be 10000 to 5000000 or 100000 to 2000000. When the weight average molecular weight is 10000 or more, there is a tendency that the heat resistance of a temporary fixing material layer to be formed is easily secured. When the weight average molecular weight is 5000000 or less, there is a tendency that deterioration of flow and deterioration of stickability are easily suppressed at the time of forming a film-shaped temporary fixing material layer or resin layer is formed. Note that, the weight average molecular weight is a value in terms of polystyrene using a calibration curve of standard polystyrene by gel permeation chromatography (GPC).

The content of the thermoplastic resin may be, for example, 40 to 90 parts by mass with respect to the total amount of 100 parts by mass of the component (B). The content of the thermoplastic resin may be, for example, 50 parts by mass or more or 60 parts by mass or more and may be 85 parts by mass or less or 80 parts by mass or less, with respect to the total amount of 100 parts by mass of the component (B). When the content of the thermoplastic resin is in the above range, there is a tendency that the thin film-formability and flatness of the temporary fixing material layer are more excellent.

The thermosetting resin means a resin that is cured by heat and is a concept that does not include the above-described hydrocarbon resin. Examples of the thermosetting resin include an epoxy resin, an acrylic resin, a silicone resin, a phenolic resin, a thermosetting polyimide resin, a polyurethane resin, a melamine resin, and a urea resin. Among these, the thermosetting resin may be an epoxy resin from the viewpoint of being more excellent in heat resistance, workability, and reliability.

The epoxy resin is not particularly limited as long as it is cured and has a heat-resistant effect. Examples of the epoxy resin include bifunctional epoxy resins such as a bisphenol A type epoxy resin, novolac type epoxy resins such as a phenol novolac type epoxy resin and a cresol novolac type epoxy resin, and alicyclic epoxy resins such as a dicyclopentadiene type epoxy resin. Furthermore, the epoxy resin may be, for example, a polyfunctional epoxy resin, a glycidylamine type epoxy resin, or a heterocyclic ring-containing epoxy resin. Among these, the epoxy resin may include an alicyclic epoxy resin from the viewpoint of heat resistance and weather resistance.

The epoxy resin as a thermosetting resin may be used alone or may be used in combination with a curing agent for an epoxy resin. Examples of the curing agent for an epoxy resin include amines, polyamides, acid anhydrides, polysulfides, boron trifluoride, bisphenols (such as bisphenol A, bisphenol F, and bisphenol S), and phenolic resins (such as a phenol novolac resin, a bisphenol A novolac resin, a cresol novolac resin, and a phenol aralkyl resin).

The content of the thermosetting resin (in the case of using an epoxy resin in combination with a curing agent for an epoxy resin, the total of the epoxy resin and the curing agent for an epoxy resin) may be 10 to 60 parts by mass with respect to the total amount of 100 parts by mass of the component (B). The content of the thermosetting resin may be 15 parts by mass or more or 20 parts by mass or more and may be 50 parts by mass or less or 40 parts by mass or less, with respect to the total amount of 100 parts by mass of the component (B). When the content of the thermosetting resin is in the above range, there is a tendency that the thin film-formability, flatness, heat resistance, and the like of the temporary fixing material layer are more excellent.

The component (B) may further contain a curing accelerator accelerating a curing reaction of a thermosetting resin such as an epoxy resin. Examples of the curing accelerator include imidazole derivatives, dicyandiamide derivatives, dicarboxylic acid dihydrazides, triphenylphosphine, tetraphenylphosphonium tetraphenylborate, 2-ethyl-4-methylimidazole-tetraphenylborate, and 1,8-diazabicyclo[5,4,0]undecene-7-tetraphenylborate.

The content of the curing accelerator may be 0.01 to 5 parts by mass with respect to the total amount of 100 parts by mass of the thermosetting resin and the curing agent for a thermosetting resin. When the content of the curing accelerator is within such a range, there is a tendency that the curability of the component (B) and heat resistance after curing are more excellent. The content of the curing accelerator may be 0.1 parts by mass or more or 0.3 parts by mass or more, and may be 3 parts by mass or less or 1 part by mass or less, with respect to the total amount of 100 parts by mass of the thermosetting resin and the curing agent for a thermosetting resin, from the viewpoint of easily adjusting the storage elastic modulus.

The component (B) may further include a polymerizable monomer and a polymerization initiator. The polymerizable monomer is not particularly limited as long as it can be polymerized by heating or irradiation with ultraviolet light or the like. The polymerizable monomer may be, for example, a compound having a polymerizable functional group such as an ethylenically unsaturated group from the viewpoint of selectivity and easy availability of a material. Examples of the polymerizable monomer include (meth)acrylate, vinylidene halide, vinyl ether, vinyl ester, vinylpyridine, vinylamide, and arylated vinyl. Among these, the polymerizable monomer may be (meth)acrylate. The (meth)acrylate may be any of a monofunctional (unifunctional), bifunctional, or trifunctional or higher-functional (meth)acrylate, but from the viewpoint of obtaining sufficient curability, the (meth)acrylate may be a bifunctional or higher-functional (meth)acrylate.

Examples of the monofunctional (meth)acrylate include (meth)acrylic acid; aliphatic (meth)acrylates such as methyl (meth)acrylate, ethyl (meth)acrylate, butyl (meth)acrylate, isobutyl (meth)acrylate, tert-butyl (meth)acrylate, butoxyethyl (meth)acrylate, isoamyl (meth)acrylate, hexyl (meth)acrylate, 2-ethylhexyl (meth)acrylate, heptyl (meth)acrylate, octylheptyl (meth)acrylate, nonyl (meth)acrylate, decyl (meth)acrylate, 2-hydroxyethyl (meth)acrylate, 2-hydroxypropyl (meth)acrylate, 3-chloro-2-hydroxypropyl (meth)acrylate, 2-hydroxybutyl (meth)acrylate, methoxy polyethylene glycol (meth)acrylate, ethoxy polyethylene glycol (meth)acrylate, methoxy polypropylene glycol (meth)acrylate, ethoxy polypropylene glycol (meth)acrylate, and mono(2-(meth)acryloyloxyethyl) succinate; and aromatic (meth)acrylates such as benzyl (meth)acrylate, phenyl (meth)acrylate, o-biphenyl (meth)acrylate, 1-naphthyl (meth)acrylate, 2-naphthyl (meth)acrylate, phenoxyethyl (meth)acrylate, p-cumylphenoxyethyl (meth)acrylate, o-phenylphenoxyethyl (meth)acrylate, 1-naphthoxyethyl (meth)acrylate, 2-naphthoxyethyl (meth)acrylate, phenoxy polyethylene glycol (meth)acrylate, nonylphenoxy polyethylene glycol (meth)acrylate, phenoxy polypropylene glycol (meth)acrylate, 2-hydroxy-3-phenoxypropyl (meth)acrylate, 2-hydroxy-3-(o-phenylphenoxy)propyl (meth)acrylate, 2-hydroxy-3-(1-naphthoxy)propyl (meth)acrylate, and 2-hydroxy-3-(2-naphthoxy)propyl (meth)acrylate.

Examples of the bifunctional (meth)acrylate include aliphatic (meth)acrylates such as ethylene glycol di(meth)acrylate, diethylene glycol di(meth)acrylate, triethylene glycol di(meth)acrylate, tetraethylene glycol di(meth)acrylate, polyethylene glycol di(meth)acrylate, propylene glycol di(meth)acrylate, dipropylene glycol di(meth)acrylate, tripropylene glycol di(meth)acrylate, tetrapropylene glycol di(meth)acrylate, polypropylene glycol di(meth)acrylate, ethoxylated polypropylene glycol di(meth)acrylate, 1,3-butanediol di(meth)acrylate, 1,4-butanediol di(meth)acrylate, neopentyl glycol di(meth)acrylate, 3-methyl-1,5-pentanediol di(meth)acrylate, 1,6-hexanediol di(meth)acrylate, 2-butyl-2-ethyl-1,3-propanediol di(meth)acrylate, 1,9-nonanediol di(meth)acrylate, 1,10-decanediol di(meth)acrylate, glycerin di(meth)acrylate, tricyclodecane dimethanol (meth)acrylate, and ethoxylated 2-methyl-1,3-propanediol di(meth)acrylate; and aromatic (meth)acrylates such as ethoxylated bisphenol A type di(meth)acrylate, propoxylated bisphenol A type di(meth)acrylate, ethoxylated propoxylated bisphenol A type di(meth)acrylate, ethoxylated bisphenol F type di(meth)acrylate, propoxylated bisphenol F type di(meth)acrylate, ethoxylated propoxylated bisphenol F type di(meth)acrylate, ethoxylated fluorene type di(meth)acrylate, propoxylated fluorene type di(meth)acrylate, and ethoxylated propoxylated fluorene type di(meth)acrylate.

Examples of the polyfunctional (meth)acrylate with trifunctionality or higher functionality include aliphatic (meth)acrylates such as trimethylolpropane tri(meth)acrylate, ethoxylated trimethylolpropane tri(meth)acrylate, propoxylated trimethylolpropane tri(meth)acrylate, ethoxylated propoxylated trimethylolpropane tri(meth)acrylate, pentaerythritol tri(meth)acrylate, ethoxylated pentaerythritol tri(meth)acrylate, propoxylated pentaerythritol tri(meth)acrylate, ethoxylated propoxylated pentaerythritol tri(meth)acrylate, pentaerythritol tetra(meth)acrylate, ethoxylated pentaerythritol tetra(meth)acrylate, propoxylated pentaerythritol tetra(meth)acrylate, ethoxylated propoxylated pentaerythritol tetra(meth)acrylate, ditrimethylolpropane tetraacrylate, and dipentaerythritol hexa(meth)acrylate; and aromatic epoxy (meth)acrylates such as phenol novolac type epoxy (meth)acrylate and cresol novolac type epoxy (meth)acrylate. These (meth)acrylates may be used in combination with other polymerizable monomers.

The content of the polymerizable monomer may be 0 to 50 parts by mass with respect to the total amount of 100 parts by mass of the component (B).

The polymerization initiator is not particularly limited as long as it is an agent that initiates polymerization by heating or irradiation with ultraviolet light or the like. For example, in the case of using a compound having an ethylenically unsaturated group as the polymerizable monomer, the polymerization initiator may be a thermal radical polymerization initiator or a photoradical polymerization initiator.

Examples of the thermal radical polymerization initiator include diacyl peroxides such as octanoyl peroxide, lauroyl peroxide, stearyl peroxide, and benzoyl peroxide; peroxy esters such as t-butyl peroxypivalate, t-hexyl peroxypivalate, 1,1,3,3-tetramethylbutyl peroxy-2-ethylhexanoate, 2,5-dimethyl-2,5-bis(2-ethylhexanoylperoxy)hexane, t-hexyl peroxy-2-ethylhexanoate, t-butyl peroxy-2-ethylhexanoate, t-butyl peroxyisobutyrate, t-hexyl peroxyisopropyl monocarbonate, t-butyl peroxy-3,5,5-trimethylhexanoate, t-butyl peroxylaurylate, t-butyl peroxyisopropyl monocarbonate, t-butyl peroxy-2-ethylhexyl monocarbonate, t-butyl peroxybenzoate, t-hexyl peroxybenzoate, 2,5-dimethyl-2,5-bis(benzoylperoxy)hexane, and t-butyl peroxyacetate; and azo compounds such as 2,2'-azobisisobutyronitrile, 2,2'-azobis(2,4-dimethylvaleronitrile), and 2,2'-azobis(4-methoxy-2'-dimethylvaleronitrile).

Examples of the photoradical polymerization initiator include 2,2-benzoin ketals such as dimethoxy-1,2-diphenylethan-1-one; $\alpha$-hydroxy ketones such as 1-hydroxycyclohexyl phenyl ketone, 2-hydroxy-2-methyl-1 -phenylpropan-1-one, and 1-[4-(2-hydroxyethoxy)phenyl]-2-hydroxy-2-methyl-1-propan-1-one; and phosphine oxides such as bis(2,4,6-trimethylbenzoyl)phenyl phosphine oxide, bis(2,6-dimethoxybenzoyl)-2,4,4-trimethylpentyl phosphine oxide, and 2,4,6-trimethylbenzoyl diphenyl phosphine oxide.

The content of the polymerization initiator may be 0.01 to 5 parts by mass with respect to the total amount of 100 parts by mass of the polymerizable monomer.

The component (B) may be the main component of the film for temporary fixing 10. The content of the component (B) may be 70% by mass or more, 80% by mass or more, 85% by mass or more, 90% by mass or more, or 95% by mass or more, based on the total amount of the film for temporary fixing.

The film for temporary fixing 10 may further contain an insulating filler, a sensitizer, an oxidation inhibitor, and the like as other components.

The insulating filler may be added for the purpose of imparting low thermal expansion properties and low hygroscopic properties to the resin layer. Examples of the insulating filler include non-metallic inorganic fillers such as silica, alumina, boron nitride, titania, glass, and ceramics. The insulating filler may be particles having the surface treated with a surface treatment agent from the viewpoint of dispersibility with a solvent. The surface treatment agent may be, for example, a silane coupling agent.

The content of the insulating filler may be 0.1 to 20 parts by mass with respect to the total amount of 100 parts by mass of the component (B). When the content of the insulating filler is within the above range, there is a tendency that heat resistance can be further improved without obstructing light transmission. Furthermore, when the content of the insulating filler is within the above range, there is also a possibility of contributing to light releasability.

Examples of the sensitizer include anthracene, phenanthrene, chrysene, benzopyrene, fluoranthene, rubrene, pyrene, xanthone, indanthrene, thioxanthen-9-one, 2-isopropyl-9H-thioxanthen-9-one, 4-isopropyl-9H-thioxanthen-9-one, and 1-chloro-4-propoxythioxanthone.

The content of the sensitizer may be 0.01 to 10 parts by mass with respect to the total amount of 100 parts by mass of the component (B). When the content of the sensitizer is within the above range, there is a tendency that the influence on characteristics and thin film properties of the component (B) is small.

Examples of the oxidation inhibitor include quinone derivatives such as benzoquinone and hydroquinone, phenol derivatives (hindered phenol derivatives) such as 4-methoxyphenol and 4-t-butylcatechol, aminoxyl derivatives such as 2,2,6,6-tetramethylpiperidin-1-oxyl and 4-hydroxy-2,2,6,6-tetramethylpiperidin-1-oxyl, and hindered amine derivatives such as tetramethylpiperidyl methacrylate.

The content of the oxidation inhibitor may be 0.1 to 10 parts by mass with respect to the total amount of 100 parts by mass of the component (B). When the content of the oxidation inhibitor is within the above range, there is a tendency that decomposition of the component (B) is suppressed and contamination can be prevented.

The thickness of the film for temporary fixing 10 may be, for example, 0.1 $\mu$m or more, 1 $\mu$m or more, 5 $\mu$m or more, more than 5 $\mu$m, 6 $\mu$m or more, 8 $\mu$m or more, or 10 $\mu$m or more, and may be 200 $\mu$m or less, 100 $\mu$m or less, or 50 $\mu$m or less.

In the film for temporary fixing 10, a parallel light transmittance at at least one wavelength of a wavelength of 550 nm and a wavelength of 1064 nm may be 30% or less. This parallel light transmittance may be 25% or less, 20% or less, 15% or less, 10% or less, 5% or less, or 3% or less. It is preferable that the film for temporary fixing 10 has both a parallel light transmittance at a wavelength of 550 nm and a parallel light transmittance at a wavelength of 1064 nm within the above range.

In the present specification, the parallel light transmittance means a transmittance as measured on the same positive line as the incident light beam. The parallel light transmittance is determined by subtracting diffuse transmittance from total light transmittance in accordance with JIS K 7136:2000, and can be measured using, for example, a spectrophotometric measuring apparatus. Since the parallel light transmittance at a wavelength of 550 nm mainly corresponds to the parallel light transmittance for visible light, it can be said that the smaller the numerical value, the more difficult it is for visible light to pass through. In other words, it can be said that as the numerical value of the parallel light transmittance at a wavelength of 550 nm is smaller, there is a tendency that particularly the component (A) is likely to absorb visible light and generate heat. Since the parallel light transmittance at a wavelength of 1064 nm mainly corresponds to the parallel light transmittance for infrared light (near-infrared light), it can be said that the smaller the numerical value, the more difficult it is for infrared light (near-infrared light) to pass through. In other words, it can be said that as the numerical value of the parallel light transmittance at a wavelength of 1064 nm is smaller, there is a tendency that particularly the component (A) is likely to absorb infrared light (near-infrared light) and generate heat.

According to such a film for temporary fixing 10, it becomes possible to form a temporary fixing material layer excellent in adhesiveness between the support member and the semiconductor member and also excellent in separability at the time of separating the semiconductor member from the support member by light irradiation, in the case of producing a semiconductor device by a method including separating the semiconductor member from the temporary fixing material layer by light irradiation.

[Method for producing film for temporary fixing]

For the film for temporary fixing 10, for example, first, a varnish of a composition for forming a film for temporary fixing is prepared by dissolving or dispersing the component (A), the component (B), and other components as necessary in a solvent by stirring, mixing, kneading, or the like. Thereafter, the varnish of a composition for forming a film for temporary fixing is applied onto a support film that has been subjected to a release treatment, by using a knife coater, a roll coater, an applicator, a comma coater, a die coater, or the like, and then the solvent is volatilized by heating to form the film for temporary fixing 10 formed from the composition for forming a film for temporary fixing on the support film. The film for temporary fixing 10 may include a protective film layered on a surface on a side opposite to the support film. The thickness of the film for temporary fixing 10 can be adjusted by adjusting the amount of application of the varnish of the composition for forming a film for temporary fixing.

The solvent used for the preparation of the varnish of the composition for forming a film for temporary fixing is not particularly limited as long as it has characteristics capable of uniformly dissolving or dispersing each component. Examples of such a solvent include aromatic hydrocarbons such as toluene, xylene, mesitylene, cumene, and p-cymene; aliphatic hydrocarbons such as hexane and heptane; cyclic alkanes such as methylcyclohexane; cyclic ethers such as tetrahydrofuran and 1,4-dioxane; ketones such as acetone, methyl ethyl ketone, methyl isobutyl ketone, cyclohexanone, and 4-hydroxy-4-methyl-2-pentanone; esters such as methyl acetate, ethyl acetate, butyl acetate, methyl lactate, ethyl lactate, and $\gamma$-butyrolactone; carbonic esters such as ethylene carbonate and propylene carbonate; and amides such as N,N-dimethylformamide, N,N-dimethylacetamide, and N-methyl-2-pyrrolidone. Among these, from the viewpoints of solubility and a boiling point, the solvent may be toluene, xylene, heptane, or cyclohexanone. The solid component concentration in the varnish may be 10 to 80% by mass based on the total mass of the varnish.

Stirring and mixing or kneading at the time of preparing the varnish of the composition for forming a film for temporary fixing can be performed by using, for example, a stirrer, a Raikai mixer, a three-roll mill, a ball mill, a bead mill, a homodisper, or the like.

Examples of the support film include films of polyesters such as polyethylene terephthalate (PET), polybutylene terephthalate, and polyethylene naphthalate; polyolefins such as polyethylene and polypropylene; polycarbonate, polyamide, polyimide, polyamideimide, polyether imide, polyether sulfide, polyether sulfone, polyether ketone, polyphenylene ether, polyphenylene sulfide, poly(meth)acrylate, polysulfone, and a liquid crystal polymer. These support films may be subjected to a release treatment. The thickness of the support film may be, for example, 1 to 250 $\mu$m.

The heating conditions at the time of volatilizing the solvent from the varnish of the composition for forming a film for temporary fixing applied to the support film can be appropriately set according to the solvent used and the like. The heating conditions may be, for example, a heating temperature of 40 to 120°C and a heating time of 0.1 to 30 minutes.

Examples of the protective film include those exemplified as the support film described above. The thickness of the protective film may be, for example, 1 to 250 $\mu$m.

[Laminated body for temporary fixing and producing method therefor]

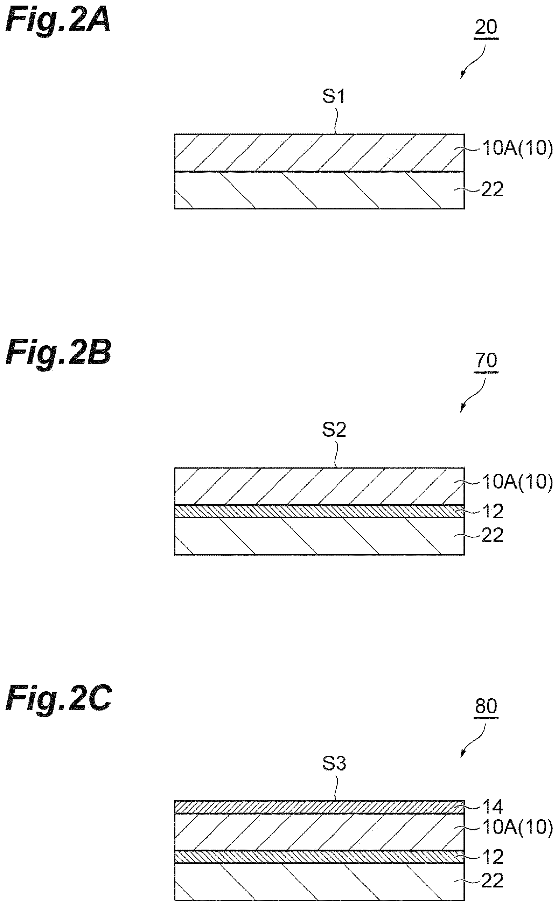

The configuration of a laminated body for temporary fixing is not particularly limited as long as it includes a support member and a temporary fixing material layer formed from the above-described film for temporary fixing. FIGS. 2A, 2B, and 2C are schematic cross-sectional views illustrating an embodiment of a laminated body for temporary fixing.

Examples of the configuration of the laminated body for temporary fixing include the configuration of a laminated body for temporary fixing 20 illustrated in FIG. 2A, the configuration of a laminated body for temporary fixing 70 illustrated in FIG. 2B, and the configuration of a laminated body for temporary fixing 80 illustrated in FIG. 2C. The laminated body for temporary fixing 20 includes a support member 22 and a temporary fixing material layer 10A formed from the film for temporary fixing 10, the temporary fixing material layer 10A provided on the support member 22. In the laminated body for temporary fixing 20, the temporary fixing material layer 10A has a surface S1 on a side opposite to the support member 22. The laminated body for temporary fixing 70 includes the support member 22, a first curable resin layer 12 formed from a first curable resin film, and the temporary fixing material layer 10A formed from the film for temporary fixing 10, in this order. In the laminated body for temporary fixing 70, the temporary fixing material layer 10A has a surface S2 on a side opposite to the first curable resin layer 12. The laminated body for temporary fixing 80 further includes a second curable resin layer 14 formed from a second curable resin film, the second curable resin layer 14 provided on a side on the temporary fixing material layer 10A opposite to the first curable resin layer 12, in the laminated body for temporary fixing 70. The second curable resin layer 14 has a surface S3 on a side opposite to the temporary fixing material layer 10A. Furthermore, examples of other configuration of the laminated body for temporary fixing include a configuration in which a support member, a temporary fixing material layer formed from a film for temporary fixing, and a curable resin layer (a first curable resin layer formed from a first curable resin film or a second curable resin layer formed from a second curable resin film) are provided in this order. According to such a laminated body for temporary fixing, since at least the temporary fixing material layer 10A is provided, when the semiconductor member is disposed, adhesiveness between the semiconductor member and the support member is excellent, and separability at the time of separating the semiconductor member from the support member by light irradiation is also excellent. In the following, an embodiment mainly using the laminated body for temporary fixing 20 illustrated in FIG. 2A will be described in detail as an example.

A method for producing the laminated body for temporary fixing 20 is not particularly limited as long as a laminated body for temporary fixing having a predetermined configuration can be obtained. The laminated body for temporary fixing 20 can be obtained, for example, by a method including a step of sticking the above-described film for temporary fixing 10 onto the support member 22. Furthermore, the laminated body for temporary fixing 20 can also be obtained, for example, by a method including a step of applying a varnish of a composition for forming a film for temporary fixing onto the support member 22 and volatilizing the solvent by heating to form the temporary fixing material layer 10A on the support member 22.

The support member 22 is a plate-shaped body that has a high transmittance and can withstand a load received at the time of processing the semiconductor member. Examples of the support member 22 include an inorganic glass substrate and a transparent resin substrate.

The thickness of the support member 22 may be, for example, 0.1 to 2.0 mm. When the thickness of the support member 22 is 0.1 mm or more, there is a tendency that handleability becomes easier. When the thickness of the support member 22 is 2.0 mm or less, there is a tendency that the material cost can be suppressed.

Examples of the method of sticking the above-described film for temporary fixing 10 onto the support member 22 include methods such as heat pressing, roll lamination, and vacuum lamination. Lamination can be performed, for example, under the temperature conditions of 0 to 120°C.

The temporary fixing material layer 10A may be a layer formed from the film for temporary fixing 10. The thickness of the temporary fixing material layer 10A may be, for example, 0.1 $\mu$m or more, 1 $\mu$m or more, 5 $\mu$m or more, more than 5 $\mu$m, 6 $\mu$m or more, 8 $\mu$m or more, or 10 $\mu$m or more, and may be 200 $\mu$m or less, 100 $\mu$m or less, or 50 $\mu$m or less, from the viewpoint of stress relaxation. When the thickness of the temporary fixing material layer 10A is increased, the parallel light transmittance at a wavelength of 550 nm and the parallel light transmittance at a wavelength of 1064 nm of the temporary fixing material layer 10A can be reduced, and there is a tendency that the parallel light transmittance is easily adjusted in a predetermined range (for example, 30% or less).

The thickness of the temporary fixing material layer 10A can be arbitrarily set according to the configuration of the laminated body for temporary fixing. The thickness of the temporary fixing material layer 10A in the configuration of the laminated body for temporary fixing 20 illustrated in FIG. 2A and the configuration of the laminated body for temporary fixing 70 illustrated in FIG. 2B may be in the same range as described above. On the other hand, the thickness of the temporary fixing material layer 10A in the configuration of the laminated body for temporary fixing 80 illustrated in FIG. 2C may be, for example, 0.1 $\mu$m or more, 1 $\mu$m or more, 5 $\mu$m or more, more than 5 $\mu$m, or 6 $\mu$m or more, and may be 50 $\mu$m or less, 30 $\mu$m or less, 20 $\mu$m or less, or 15 $\mu$m or less.

The laminated body for temporary fixing 70 includes the support member 22, a first curable resin layer 12 formed from a first curable resin film, and the temporary fixing material layer 10A formed from the film for temporary fixing 10, in this order. When the laminated body for temporary fixing 70 includes the first curable resin layer 12 formed from a first curable resin film, there is a tendency that heat radiation to the support member is reduced and the energy of light irradiation is likely to be efficiently converted into heat. Furthermore, since scorching of a resin such as a film for temporary fixing to the support member can be suppressed, there is a tendency that the resin residue is easily removed from the support member. The laminated body for temporary fixing 80 is an embodiment further including a second curable resin layer 14 formed from a second curable resin film, the second curable resin layer 14 provided on a side on the temporary fixing material layer 10A opposite to the first curable resin layer 12, in the laminated body for temporary fixing 70. Since the laminated body for temporary fixing 80 includes the second curable resin layer 14 formed from a second curable resin film, there is a tendency that thermal damage to the semiconductor member is easily suppressed. Furthermore, since scorching of a resin such as a film for temporary fixing to the semiconductor member can be suppressed, there is a tendency that the resin residue is easily removed from the semiconductor member.

The first curable resin film and the second curable resin film are not particularly limited as long as they are each a resin film exhibiting curability, but these curable resin films may contain the component (B) in the above-described film for temporary fixing 10 and other components. Note that, it is preferable that the first curable resin film and the second curable resin film do not contain the component (A). In the first curable resin film and the second curable resin film, preferred embodiments of the type, content, and the like of the component (B), preferred embodiments of the type, content, and the like of the other components, and the like are the same as the preferred embodiments of the type, content, and the like of the component (B), the preferred embodiments of the type, content, and the like of the other components, and the like in the film for temporary fixing 10. Therefore, herein the duplicate description will be omitted. The first curable resin film and the second curable resin film may be the same as or different from each other, and may be the same as each other. Furthermore, the first curable resin film and the second curable resin film can be obtained by the same method as the method for producing a film for temporary fixing, except that the component (A) is not used.

In the first curable resin film and the second curable resin film, the component (B) may be a main component. The content of the component (B) may be 90% by mass or more, 95% by mass or more, or 98% by mass or more, based on the total amount of the first curable resin film or the second curable resin film.

In the first curable resin film, a parallel light transmittance at at least one wavelength of a wavelength of 550 nm and a wavelength of 1064 nm may be 80% or more. This parallel light transmittance may be 85% or more, 87% or more, 90% or more, 92% or more, or 95% or more. When this parallel light transmittance of the first curable resin film is set in such a range, the light irradiated to the laminated body for temporary fixing from the support member side is easily transmitted, so that a decrease in separability can be suppressed. It is preferable that the first curable resin film has both a parallel light transmittance at a wavelength of 550 nm and a parallel light transmittance at a wavelength of 1064 nm within the above range.

The thickness of the first curable resin film may be, for example, 0.1 $\mu$m or more, 1 $\mu$m or more, or 5 $\mu$m or more, and may be 200 $\mu$m or less, 100 $\mu$m or less, 50 $\mu$m or less, or 30 $\mu$m or less, from the viewpoint of achieving both heat insulating properties and light transparency.

In the second curable resin film, a parallel light transmittance at at least one wavelength of a wavelength of 550 nm and a wavelength of 1064 nm is not particularly limited, and may be the same as the parallel light transmittance of the first curable resin film.

The thickness of the second curable resin film may be, for example, 0.1 $\mu$m or more, 1 $\mu$m or more, or 5 $\mu$m or more, and may be 200 $\mu$m or less, 100 $\mu$m or less, 50 $\mu$m or less, or 30 $\mu$m or less, from the viewpoint of achieving both heat insulating properties and handleability.

A method for producing the laminated body for temporary fixing 70 or 80 is not particularly limited as long as a laminated body for temporary fixing having a predetermined configuration can be obtained. The laminated body for temporary fixing 70 can be obtained, for example, by a method including a step of sticking the above-described first curable resin film onto the support member 22, and a step of sticking the above-described film for temporary fixing 10 onto the above-described first curable resin film (first curable resin layer 12) to form the temporary fixing material layer 10A. The first curable resin layer 12 can also be obtained by applying a varnish for forming a first curable resin film onto the support member 22 and volatilizing the solvent by heating. The temporary fixing material layer 10A can also be obtained, for example, by applying a varnish of a composition for forming a film for temporary fixing onto the first curable resin layer 12 and volatilizing the solvent by heating. The laminated body for temporary fixing 80 can be obtained, for example, by a method including a step of sticking the above-described second curable resin film onto the above-described film for temporary fixing 10 (temporary fixing material layer 10A) in the laminated body for temporary fixing 70. The second curable resin layer 14 can also be obtained by applying a varnish for forming a second curable resin film onto the temporary fixing material layer 10A and volatilizing the solvent by heating.

[Method for producing semiconductor device]

A method for producing a semiconductor device of an embodiment includes a step of preparing the above-described laminated body for temporary fixing (preparation step), a step of temporarily fixing a semiconductor member to the support member with the temporary fixing material layer interposed therebetween (temporary fixing step), a step of processing the semiconductor member temporarily fixed to the support member (processing step), and a step of separating the semiconductor member from the support member by irradiating the temporary fixing material layer of the laminated body for temporary fixing with light from the support member side (separation step). In the following, an embodiment mainly using the laminated body for temporary fixing 20 illustrated in FIG. 2A will be described in detail as an example.

(Preparation step)

In the preparation step, in order to produce a semiconductor device, the above-described laminated body for temporary fixing 20 for temporarily fixing the semiconductor member to the support member is prepared during processing the semiconductor member.

(Temporary fixing step)

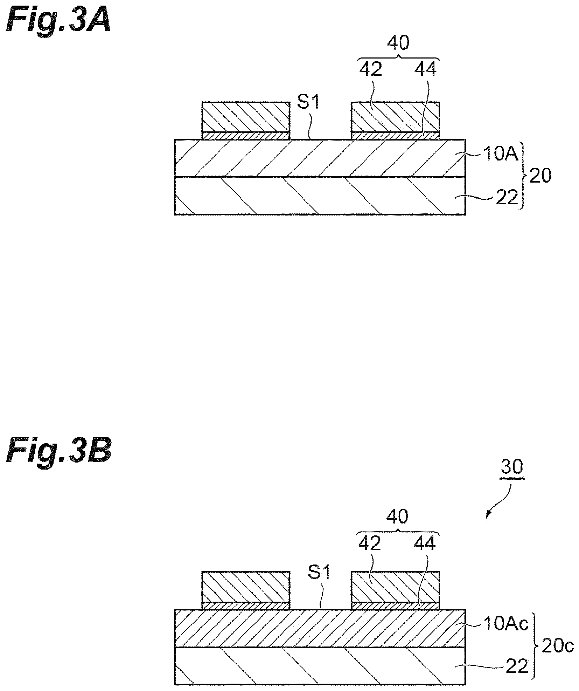

FIGS. 3A and 3B are schematic cross-sectional views illustrating an embodiment of a method for producing a semiconductor device. In the temporary fixing step, a semiconductor member 40 is temporarily fixed to the support member 22 with the temporary fixing material layer 10A interposed therebetween. The temporary fixing material layer 10A has the surface S 1 on a side of the temporary fixing material layer 10A opposite to the support member 22. In the temporary fixing step, for example, the temporary fixing material layer 10A (film for temporary fixing 10) is cured in a state where the semiconductor member 40 is disposed on the temporary fixing material layer 10A (see FIG. 3A), so that the semiconductor member 40 can be temporarily fixed to the support member 22 (see FIG. 3B). In other words, the semiconductor member 40 can be temporarily attached to the support member 22 with a temporary fixing material layer 10Ac, which contains a cured product of the film for temporary fixing 10 (cured product of the component (B)), interposed therebetween. In this way, a laminated body 30 including a laminated body for temporary fixing 20c and the semiconductor member 40 provided on the laminated body for temporary fixing 20c is formed.

The semiconductor member 40 may be a member having a semiconductor substrate 42 such as a semiconductor wafer or a semiconductor chip obtained by dividing a semiconductor wafer. The semiconductor member 40 may be, for example, a semiconductor chip attached with a redistribution layer having a redistribution layer 44 and the semiconductor substrate 42. In a case where the semiconductor member 40 is a semiconductor chip attached with a redistribution layer, the semiconductor chip attached with a redistribution layer is temporarily fixed to the support member 22 with the temporary fixing material layer 10A interposed therebetween in a direction in which the redistribution layer is located on the temporary fixing material layer 10A side. The semiconductor member 40 may further has an external connection terminal. In an example of FIG. 3A, a plurality of semiconductor members 40 are disposed on the surface S 1 of the temporary fixing material layer 10A, but the number of semiconductor members 40 may be one. The thickness of the semiconductor member 40 may be 1 to 1000 $\mu$m, 10 to 500 $\mu$m, or 20 to 200 $\mu$m, from the viewpoint of suppressing cracking during conveyance and at the time of processing step, or the like, in addition to miniaturization and thickness reduction of semiconductor devices.

The semiconductor member 40 disposed on the temporary fixing material layer 10A is pressure-bonded to the temporary fixing material layer 10A by using, for example, a vacuum pressing machine or a vacuum laminator. In the case of using a vacuum pressing machine, the conditions for pressure-bonding may be an air pressure of 1 hPa or less, a pressure-bonding pressure of 1 MPa, a pressure-bonding temperature of 120 to 200°C, and a retention time of 100 to 300 seconds. In the case of using a vacuum laminator, the conditions for pressure-bonding may be, for example, an air pressure of 1 hPa or less, a pressure-bonding temperature of 60 to 180°C or 80 to 150°C, a lamination pressure of 0.01 to 1.0 MPa or 0.1 to 0.7 MPa, and a retention time of 1 to 600 seconds or 30 to 300 seconds.

After the semiconductor member 40 is disposed on the temporary fixing material layer 10A, by thermally curing or photocuring the component (B) in the temporary fixing material layer 10A, the semiconductor member 40 is temporarily fixed to the support member 22 with the temporary fixing material layer 10Ac containing a cured product of the film for temporary fixing 10 (cured product of the component (B)) interposed therebetween. The conditions for thermal curing may be, for example, 300°C or lower or 100 to 250°C for 1 to 180 minutes or 1 to 120 minutes.

(Processing step)

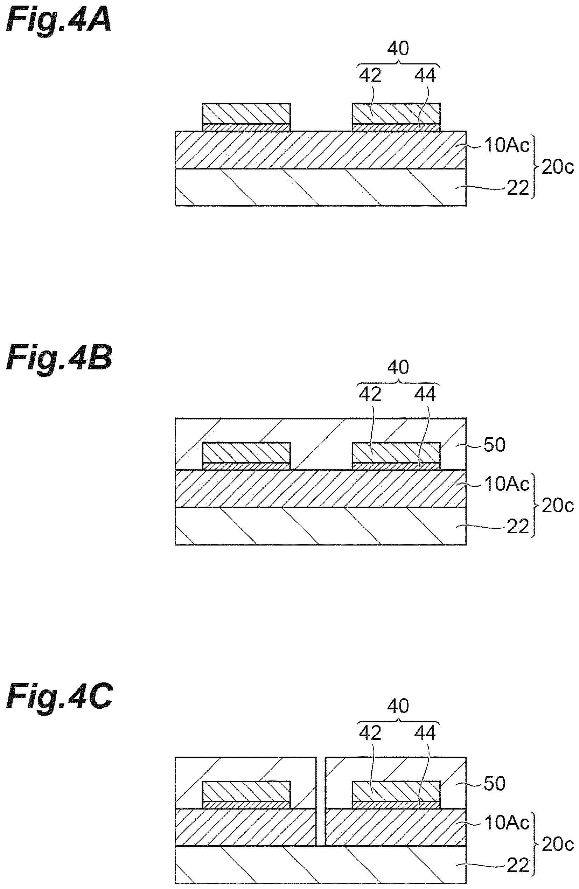

FIGS. 4A, 4B, and 4C are schematic cross-sectional views illustrating an embodiment of the method for producing a semiconductor device. In the processing step, the semiconductor member 40 temporarily fixed to the support member 22 is processed. FIG. 4A shows an example of processing including thinning of the semiconductor substrate. Processing of the semiconductor member is not limited thereto, and can include, for example, thinning of the semiconductor substrate, division (dicing) of the semiconductor member, formation of a through electrode (silicon through electrode), an etching treatment, a plating reflow treatment, a sputtering treatment, or a combination of these.

After the processing of the semiconductor member 40, as illustrated in FIG. 4B, a sealing layer 50 sealing the processed semiconductor member 40 is formed. The sealing layer 50 can be formed using a sealing material generally used for the production of a semiconductor element. For example, the sealing layer 50 may be formed by a thermosetting resin composition. Examples of the thermosetting resin composition used for the sealing layer 50 include epoxy resins such as a cresol novolac epoxy resin, a phenol novolac epoxy resin, a biphenyl diepoxy resin, and a naphthol novolac epoxy resin. The sealing layer 50 and the thermosetting resin composition for forming the sealing layer 50 may contain a filler and/or an additive such as a flame retardant.

The sealing layer 50 is formed using, for example, a solid material, a liquid material, a fine granular material, or a sealing film. In the case of using a sealing film, a compression sealing molding machine, a vacuum lamination apparatus, and the like are used. For example, the sealing layer 50 can be formed by coating the semiconductor member 40 with a sealing film that has been thermally melted using these apparatuses under the conditions of 40 to 180°C (or 60 to 150°C), 0.1 to 10 MPa (or 0.5 to 8 MPa), and 0.5 to 10 minutes. The thickness of the sealing film is adjusted such that the sealing layer 50 has a thickness equal to or more than the thickness of the semiconductor member 40 after processing. The thickness of the sealing film may be 50 to 2000 $\mu$m, 70 to 1500 $\mu$m, or 100 to 1000 $\mu$m.

After the sealing layer 50 is formed, as illustrated in FIG. 4C, the sealing layer 50 and the temporary fixing material layer 10Ac may be divided into a plurality of portions each including one semiconductor member 40.

(Separation step)

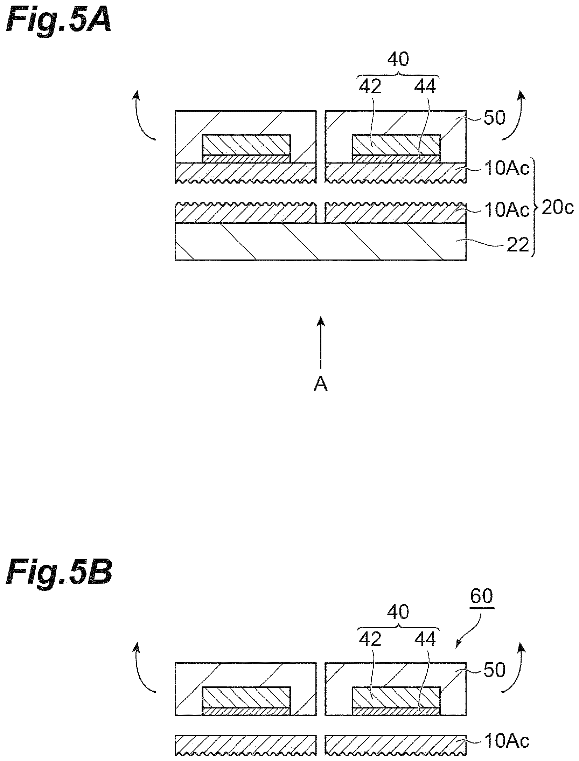

FIGS. 5A and 5B are schematic cross-sectional views illustrating an embodiment of the method for producing a semiconductor device. As illustrated in FIG. 5A, the temporary fixing material layer 10Ac of the laminated body for temporary fixing 20c is irradiated with light A from the support member 22 side to separate the semiconductor member 40 from the support member 22. The light A may be light including any of infrared light (near-infrared light), visible light, or ultraviolet light, may be light including any of infrared light (near-infrared light) or visible light, and may be light including at least infrared light (near-infrared light). As a result of irradiation with the light A, the component (A) in the temporary fixing material layer 10Ac absorbs the light A and instantaneously generates heat. Due to the generated heat, for example, melting of the cured product of the component (B) in the temporary fixing material layer 10Ac, thermal stress generated between the support member 22 and the semiconductor member 40, and scattering of the component (A) or the component (B) may occur. One or two or more these phenomena are the main causes of the occurrence of cohesive peeling, interface peeling, and the like, and the semiconductor member 40 can be easily separated from the support member 22. In order to separate the semiconductor member 40 from the support member 22, stress may be slightly applied to the semiconductor member 40 together with irradiation with the light A.

The light A in the separation step may be coherent light. The coherent light electromagnetic waves having properties such as high coherence, high directivity, and high monochromaticity. The coherent light tends to have high intensity because light beams having the same wavelength and the same phase are synthesized by intensifying each other. Laser light is generally coherent light. Examples of the laser light include a YAG (Yttrium Aluminum Garnet) laser, a fiber laser, a semiconductor laser, a helium-neon laser, an argon laser, and an excimer laser. The wavelength of the laser light may be 1300 nm or less. When the wavelength is 1300 nm or less, light absorption of the support member 22 is suppressed and light absorption by the component (A) is increased, so that peeling is enabled with lower light irradiation energy. The coherent light may be pulsed light. It is preferable to irradiate the entire surface of the support member with the coherent light.

The light A in the separation step may be incoherent light. The incoherent light is light that is not coherent, which is electromagnetic waves having properties such as no generation of interference fringes, low coherence, and low directivity. The incoherent light tends to be attenuated as the optical path length is longer. Light such as solar light and the light of a fluorescent lamp is incoherent light. The incoherent light can also be considered as light excluding laser light. Since the irradiation area of incoherent light is generally overwhelmingly larger than that of coherent light (that is, laser light), the number of times of irradiation can be decreased. For example, separation of a plurality of semiconductor members 40 can be caused by a single irradiation. The incoherent light may include infrared light. The incoherent light may be pulsed light. It is preferable to irradiate the entire surface of the support member with the incoherent light.

The light source of the incoherent light is not particularly limited, and may be a xenon lamp. The xenon lamp is a lamp utilizing light emission caused by application and discharge in an arc tube having xenon gas encapsulated therein. Since the xenon lamp is discharged while repeating ionization and excitation, the xenon lamp has a stable continuous wavelength from the ultraviolet light region to the infrared light region. Since the xenon lamp requires a shorter start time compared with lamps such as a metal halide lamp, the time related to the process can be shortened to a large extent. Furthermore, since it is necessary to apply a high voltage for light emission, high heat is generated instantaneously, but the xenon lamp is advantageous even from the viewpoint that the cooling time is short, and continuous work is possible.

The irradiation conditions for the xenon lamp include applied voltage, pulse width, irradiation time, irradiation distance (distance between the light source and the temporary fixing material layer), irradiation energy, and the like, and these can be arbitrarily set according to the number of times of irradiation and the like. From the viewpoint of reducing the damage to the semiconductor member 40, the irradiation conditions may be set such that the semiconductor member 40 can be separated by a single irradiation.

On the separated semiconductor member 40, a part of the cured product of the component (B) or a part of the component (A) may adhere as a residue. The adhered residue is removed as illustrated in FIG. 5B. The adhered residue may be removed by, for example, washing with a solvent, and may be detached by peeling. The solvent is not particularly limited, and examples thereof include ethanol, methanol, toluene, xylene, acetone, methyl ethyl ketone, methyl isobutyl ketone, and hexane. In order to remove the adhered residue, the semiconductor member 40 may be immersed in a solvent, and ultrasonic cleaning may be performed. The semiconductor member 40 may also be heated at a low temperature of about 100°C or lower.

A semiconductor element 60 including the processed semiconductor member 40 can be obtained by the above-exemplified methods. A semiconductor device can be produced by connecting the obtained semiconductor element 60 to another semiconductor element or a substrate for mounting a semiconductor element.

**Examples**

Hereinafter, the present disclosure will be more specifically described by means of Examples. However, the present disclosure is not limited to these Examples.

[Production and evaluation of film for temporary fixing]

(Examples 1-1 to 1-5 and Comparative Examples 1-1 and 1-2)

<Production of film for temporary fixing>

The following materials were used in the production of the film for temporary fixing.

Component (A): carbon black

(A-1) Acetylene black (trade name: Li-400, manufactured by Denka Company Limited, average primary particle diameter: 48 nm) Component (B): curable resin component
(B-1) Thermoplastic resin
(B-1-1) Maleic anhydride-modified styrene-ethylene-butylene-styrene block copolymer (trade name: FG1924GT, manufactured by KRATON CORPORATION, styrene content: 13% by mass), used as a xylene solution having a concentration of 25% by mass.
(B-1-2) Maleic anhydride-modified styrene-ethylene-butylene-styrene block copolymer (trade name: FG1901GT, manufactured by KRATON CORPORATION, styrene content: 30% by mass), used as a xylene solution having a concentration of 25% by mass.
(B-2) Thermosetting resin
(B-2-1) Dicyclopentadiene type epoxy resin (trade name: HP7200H, manufactured by DIC Corporation), used as a cyclohexanone solution having a concentration of 50% by mass.
(B-3) Curing accelerator
(B-3-1) Imidazole derivative (trade name: 2PZ-CN, manufactured by SHIKOKU CHEMICALS CORPORATION), used as a cyclohexanone solution having a concentration of 10% by mass. (C) Oxidation inhibitor
(C-1) Hindered phenol derivative (trade name: AO-60, manufactured by ADEKA Corporation), used as a cyclohexanone solution having a concentration of 10% by mass.

The materials shown in Table 1 were used in parts by mass shown in Table 1 (the numerical values of Table 1 mean the amount of non-volatile components). This was mixed with 302.4 parts by mass of toluene and 4.5 parts by mass of cyclohexanone as solvents to obtain a varnish of a composition for forming a film for temporary fixing. The obtained varnish of the composition for forming a film for temporary fixing was applied to a release-treated surface of a support film (PUREX A31B (trade name, easy release type, polyethylene terephthalate (PET) film, Toyobo Film Solutions, Ltd., thickness: 38 μm)) by using a precision coating machine. The coating film was heated at 100°C for 10 minutes to remove the solvent, thereby obtaining a film for temporary fixing of Example 1-1 having a thickness of 30 μm and films for temporary fixing of Examples 1-2 to 1-5 and Comparative Examples 1-1 and 1-2 each having a thickness of 10 μm. A protective film (PUREX A70J (trade name, tight release type, PET film, Toyobo Film Solutions, Ltd., thickness: 38

μm)) was pasted to a surface of the obtained film for temporary fixing on a side opposite to the support film in a direction in which the release-treated surface thereof was contact with the film for temporary fixing.

<Evaluation of film for temporary fixing>

Each parallel light transmittance was produced using each of the films for temporary fixing of Examples 1-1 to 1-5 and Comparative Examples 1-1 and 1-2. The film for temporary fixing was cut into 5 cm square pieces to obtain a sample for measurement. The parallel light transmittance when the sample for measurement was irradiated with light having a wavelength of 550 nm or a wavelength of 1064 nm and the light passed through a distance (optical path length) of the film thickness was measured using an ultraviolet-visible-near-infrared spectrophotometer SolidSpec-3700 (SHIMADZU CORPORATION) as a measuring apparatus. Results are shown in Table 1.

[Table 1]

| | | | Unit | Comp. Exam. 1-1 | Exam. 1-1 | Exam. 1-2 | Exam. 1-3 | Exam. 1-4 | Exam. 1-5 | Comp. Exam. 1-2 |
|---|---|---|---|---|---|---|---|---|---|---|
| Material | (A) | (A-1) | Parts by mass | 0.05 | 0.5 | 3 | 5 | 10 | 20 | 30 |
| | (B-1) | (B-1-1) | Parts by mass | 35 | 35 | 35 | 35 | 35 | 35 | 35 |
| | | (B-1-2) | Parts by mass | 35 | 35 | 35 | 35 | 35 | 35 | 35 |
| | (B-2) | (B-2-1) | Parts by mass | 30 | 30 | 30 | 30 | 30 | 30 | 30 |
| | (B-3) | (B-3-1) | Parts by mass | 0.5 | 0.5 | 0.5 | 0.5 | 0.5 | 0.5 | 0.5 |
| | (C) | (C-1) | Parts by mass | 0.8 | 0.8 | 0.8 | 0.8 | 0.8 | 0.8 | 0.8 |
| Volume proportion of component (A) (based on total amount of film for temporary fixing) | | | % by volume | 0.024 | 0.24 | 0.47 | 2.3 | 4.6 | 8.7 | 12.5 |
| Thickness of film for temporary fixing | | | μm | 10 | 30 | 10 | 10 | 10 | 10 | 10 |
| Parallel light transmittance | 550 nm | | % | 80 | 8.9 | 4.9 | 0.7 | 0 | 0 | 0 |
| | 1064 nm | | % | 84 | 30 | 9.3 | 2.0 | 0 | 0 | 0 |

[Production of laminated body for temporary fixing]

(Examples 2-1 to 2-5 and Comparative Examples 2-1 and 2-2)

<Production (i) of laminated body for temporary fixing>

Each laminated body for temporary fixing was produced using each of the films for temporary fixing of Examples 1-1 to 1-5 and Comparative Examples 1-1 and 1-2. The support film was peeled off from the film for temporary fixing, and the film for temporary fixing was layered on a glass substrate (trade name: EAGLE XG, manufactured by Corning Incorporated, size: 20 mm × 20 mm, thickness: 0.7 mm) as a support member by using a vacuum pressing type laminator under the conditions of a pressure of 0.5 MPa, a temperature of 100°C, and a pressurization time of 60 seconds, thereby producing laminated bodies for temporary fixing of Examples 2-1 to 2-5 and Comparative Examples 2-1 and 2-2.

<Production (i) of laminated body for test>

Next, the protective film on the side of the temporary fixing material layer formed from the film for temporary fixing on each laminated body for temporary fixing of Examples 2-1 to 2-5 and Comparative Examples 2-1 and 2-2 was peeled off, and a silicon wafer (size: 20 mm × 20 mm, thickness: 150 μm) as a semiconductor member was layered on the temporary fixing material layer by using a vacuum pressing type laminator under the conditions of a pressure of 0.5 MPa, a temperature of 100°C, and a pressurization time of 60 seconds. Thereafter, the temporary fixing material layer was cured by heating at 200°C for 1 hour to produce each laminated body for a test of Examples 2-1 to 2-5 and Comparative Examples 2-1 and 2-2, having the semiconductor member temporarily fixed to the support member.

(Example 2-6)

<Preparation of first curable resin film>

A first curable resin film having a thickness of 10 μm was produced in the same manner as in <Production of film for temporary fixing>, except that the component (A) was not used (that is, 0 parts by mass with respect to the total amount of 100 parts by mass of the curable resin component, or 0% by volume based on the total volume of the film for temporary fixing). The parallel light transmittance of the first curable resin film was measured in the same manner as in <Evaluation of film for temporary fixing>. The parallel light transmittance at a wavelength of 550 nm of the first curable resin film was 93% and the parallel light transmittance at a wavelength of 1064 nm thereof was 97%.

<Production (ii) of laminated body for temporary fixing>

A laminated body for temporary fixing was produced using the film for temporary fixing of Example 1-3 and the above-described first curable resin film. The support film was peeled off from each film, and both of the exposed surfaces were pasted using a pressing type roll laminator under the conditions of a pressure of 0.2 MPa, a temperature of 100°C, a speed of 0.2 m/min, thereby obtaining a two-layer film. Next, the protective film on a side of the first curable resin layer formed from the first curable resin film of the two-layer film was peeled off, and the two-layer film was layered in the same manner as in <Production (i) of laminated body for temporary fixing> described above in a direction in which the peeled surface thereof was in contact with the support member, thereby producing a laminated body for temporary fixing of Example 2-6.

<Production (ii) of laminated body for test>

Next, a laminated body for a test of Example 2-6 was produced by layering the semiconductor member onto the temporary fixing material layer in the same manner as in <Production (i) of laminated body for test> and curing the temporary fixing material layer and the first curable resin layer under the same conditions as in <Production (i) of laminated body for test>.

(Example 2-7)

<Preparation of first curable resin film and second curable resin film>

The first curable resin film produced in Example 2-6 was used as the first curable resin film. The same film as the first curable resin film was used as the second curable resin film.

<Production (iii) of laminated body for temporary fixing>

A laminated body for temporary fixing was produced using the film for temporary fixing of Example 1-3, the above-described first curable resin film, and the above-described second curable resin film. First, a two-layer film including the film for temporary fixing of Example 1-3 and the above-described first curable resin film was obtained in the same manner as in <Production (ii) of laminated body for temporary fixing>. Next, the protective film on the side of the temporary fixing material layer formed from the film for temporary fixing of Example 1-3 and the support film of the second curable resin film of the two-layer film were peeled off, and both of the exposed surfaces were pasted using a pressing type roll laminator under the conditions of a pressure of 0.2 MPa, a temperature of 100°C, a speed of 0.2 m/min, thereby obtaining a three-layer film. Next, the protective film on a side of the first curable resin layer formed from the first curable resin film of the three-layer film was peeled off, and the three-layer film was layered in the same manner as in <Production (i) of laminated body for temporary fixing> described above in a direction in which the peeled surface thereof was in contact with the support member, thereby producing a laminated body for temporary fixing of Example 2-7.

<Production (iii) of laminated body for test>

Next, a laminated body for a test of Example 2-7 was produced by layering the semiconductor member onto the second curable resin layer in the same manner as in <Production (i) of laminated body for test> and curing the temporary fixing material layer, the first curable resin layer, and the second curable resin layer under the same conditions as in <Production (i) of laminated body for test>.

[Evaluation of laminated body for test]

<Evaluation of adhesiveness>

For the laminated bodies for a test of Examples 2-1 to 2-7 and Comparative Examples 2-1 and 2-2, when the semiconductor member of the laminated body for a test was picked up by hand, a case where the semiconductor member and the support member were not separated was regarded to be excellent in adhesiveness and evaluated as "A", and a case where the semiconductor member and the support member were easily separated was evaluated as "B". Results are shown in Table 2 and Table 3.

<Evaluation of separability>

· Light irradiation by xenon lamp

For the laminated bodies for a test of Examples 2-1 to 2-7 and Comparative Example 2-1 which were excellent in the evaluation of adhesiveness, separability when the semiconductor member was separated from the support member by irradiation with pulsed light using a xenon lamp under the irradiation conditions of an applied voltage of 630 V and an irradiation time of 1000 $\mu$s (irradiation energy per unit area: 7.7 J/cm$^2$), was evaluated. PulseForge (registered trademark) 1300 (wavelength range: 200 nm to 1500 nm) manufactured by NovaCentrix was used as the xenon lamp, and light irradiation by the xenon lamp was performed from the support member (glass substrate) side of the laminated body for a test. For evaluation of separability, after the light irradiation by the xenon lamp, a case where the silicon wafer was separated from the glass substrate by applying external force to the silicon wafer was regarded to be excellent and evaluated as "A", and a case where the silicon wafer was not separated from the glass substrate even in the case of applying external force was evaluated as "B". Results are shown in Table 2.

· Light irradiation by laser

For the laminated bodies for a test of Examples 2-2 to 2-7 and Comparative Example 2-1, separability when the semiconductor member was separated from the support member by irradiation with near-infrared pulsed laser light using a YAG laser at a wavelength of 1064 nm, a pulsed energy of 106 $\mu$J, and a repetition frequency of 70 kHz, was evaluated. MM200-USP manufactured by Optec S.p.A. was used as the YAG laser, and for light irradiation by the laser, the entire surface of the support member was irradiated with light at a scanning speed of 3000 mm/s from the support member (glass substrate) side of the laminated body for a test. For evaluation of separability, after the light irradiation by the laser, a case where the silicon wafer was separated from the glass substrate by applying external force to the silicon wafer was regarded to be excellent and evaluated as "A", and a case where the silicon wafer was not separated from the glass substrate even in the case of applying external force was evaluated as "B". Results are shown in Table 3.

[Table 2]

| | | Comp. Exam. 2-1 | Exam. 2-1 | Exam. 2-2 | Exam. 2-3 | Exam. 2-4 | Exam. 2-5 | Comp. Exam. 2-2 | Exam. 2-6 | Exam. 2-7 |
|---|---|---|---|---|---|---|---|---|---|---|
| Layer configuration of laminated body for temporary fixing | First curable resin layer | Absent | Absent | Absent | Absent | Absent | Absent | Absent | Present | Present |
| | Temporary fixing material layer | Present | Present | Present | Present | Present | Present | Present | Present | Present |
| | | Comp. Exam. 1-1 | Exam. 1-1 | Exam. 1-2 | Exam. 1-3 | Exam. 1-4 | Exam. 1-5 | Comp. Exam. 1-2 | Exam. 1-3 | Exam. 1-3 |
| | Second curable resin layer | Absent | Absent | Absent | Absent | Absent | Absent | Absent | Absent | Present |
| Evaluation of adhesiveness | | A | A | A | A | A | A | B | A | A |
| Evaluation of separability | Xenon lamp | B | A | A | A | A | A | - | A | A |

EP 4 383 312 A1

[Table 3]

| | | Comp. Exam. 2-1 | Exam. 2-2 | Exam. 2-3 | Exam. 2-4 | Exam. 2-5 | Comp. Exam. 2-2 | Exam. 2-6 | Exam. 2-7 |
|---|---|---|---|---|---|---|---|---|---|
| Layer configuration of laminated body for temporary fixing | First curable resin layer | Absent | Absent | Absent | Absent | Absent | Ab sent | Present | Present |
| | Temporary fixing material layer | Present | Present | Present | Present | Present | Present | Present | Present |
| | | Comp. Exam. 1-1 | Exam. 1-2 | Exam. 1-3 | Exam. 1-4 | Exam. 1-5 | Comp. Exam. 1-2 | Exam. 1-3 | Exam. 1-3 |
| | Second curable resin layer | Absent | Absent | Absent | Absent | Absent | Absent | Absent | Present |
| Evaluation of adhesiveness | | A | A | A | A | A | B | A | A |
| Evaluation of separability | Laser | B | A | A | A | A | - | A | A |

As shown in Table 2 and Table 3, the laminated bodies for a test of Examples 2-1 to 2-5 produced using the films for temporary fixing of Examples 1-1 to 1-5 were excellent in terms of adhesiveness and separability. Furthermore, it was found that the laminated body for a test of Example 2-6 including the first curable resin layer and the laminated body for a test of Example 2-7 including the first curable resin layer and the second curable resin layer were also excellent in terms of adhesiveness and separability. These tendencies were similar for both the light irradiation by the xenon lamp and the light irradiation by the laser. On the other hand, the laminated body for a test of Comparative Example 2-2 in which the content of the carbon black was more than 25 parts by mass with respect to the total amount of 100 parts by mass of the curable resin component or was more than 10% by volume based on the total volume of the film for temporary fixing, was not sufficient in terms of adhesiveness. Furthermore, the laminated body for a test of Comparative Example 2-1 in which the content of the carbon black was less than 0.1 parts by mass with respect to the total amount of 100 parts by mass of the curable resin component or was less than 0.1% by volume based on the total volume of the film for temporary fixing, was sufficient in terms of adhesiveness, but was not sufficient in terms of separability.

From these results, it was confirmed that the film for temporary fixing of the present disclosure can form a temporary fixing material layer excellent in adhesiveness between the semiconductor member and the support member and also excellent in separability at the time of separating the semiconductor member from the support member by light irradiation, in the case of producing a semiconductor device by a method including separating the semiconductor member from the temporary fixing material layer by light irradiation.

**Reference Signs List**

10: film for temporary fixing, 10A, 10Ac: temporary fixing material layer, 12: first curable resin layer, 14: second curable resin layer, 20, 70, 80, 20c: laminated body for temporary fixing, 22: support member, 30: laminated body, 40: semiconductor member, 42: semiconductor substrate, 44: redistribution layer, 50: sealing layer, 60: semiconductor element.

**Claims**

1. A film for temporary fixing used for temporarily fixing a semiconductor member and a support member, comprising:

   carbon black and a curable resin component, wherein
   the curable resin component comprises a thermosetting resin and a thermoplastic resin,
   the thermoplastic resin is a hydrocarbon resin, and
   a content of the carbon black satisfies at least one condition of the following Condition (i) and Condition (ii):

   Condition (i): the content of the carbon black is 0.1 to 25 parts by mass with respect to the total amount of 100 parts by mass of the curable resin component; and
   Condition (ii): the content of the carbon black is 0.1 to 10% by volume based on the total volume of the film for temporary fixing.

2. The film for temporary fixing according to claim 1, wherein a parallel light transmittance at at least one wavelength of a wavelength of 550 nm and a wavelength of 1064 nm is 30% or less.

3. The film for temporary fixing according to claim 1, wherein a thickness is more than 5 $\mu$m.

4. A laminated body for temporary fixing, comprising: a support member; and a temporary fixing material layer formed from the film for temporary fixing according to claim 1, the temporary fixing material layer provided on the support member.

5. A laminated body for temporary fixing, comprising: a support member; a first curable resin layer formed from a first curable resin film; and a temporary fixing material layer formed from the film for temporary fixing according to claim 1, in this order.

6. The laminated body for temporary fixing according to claim 5, further comprising a second curable resin layer formed from a second curable resin film, the second curable resin layer provided on a side on the temporary fixing material layer opposite to the first curable resin layer.

7. The laminated body for temporary fixing according to claim 5, wherein a parallel light transmittance at at least one wavelength of a wavelength of 550 nm and a wavelength of 1064 nm is 80% or more in the first curable resin film.

8. A method for producing a semiconductor device, comprising:

preparing the laminated body for temporary fixing according to any one of claims 4 to 7;
temporarily fixing a semiconductor member to the support member with the temporary fixing material layer interposed therebetween;
processing the semiconductor member temporarily fixed to the support member; and
separating the semiconductor member from the support member by irradiating the temporary fixing material layer of the laminated body for temporary fixing with light from the support member side.

9. The method for producing a semiconductor device according to claim 8, wherein the light is light comprising at least infrared light.

10. The method for producing a semiconductor device according to claim 8, wherein the light is incoherent light.

## Fig.1

**Fig.2A**

**Fig.2B**

**Fig.2C**

*Fig.3A*

*Fig.3B*

**Fig.4A**

**Fig.4B**

**Fig.4C**

**Fig.5A**

**Fig.5B**

## INTERNATIONAL SEARCH REPORT

| | International application No. |
|---|---|
| | **PCT/JP2022/032589** |

**A. CLASSIFICATION OF SUBJECT MATTER**

*H01L 21/02*(2006.01)i; *H01L 21/56*(2006.01)i
FI:   H01L21/02 C; H01L21/56 R

According to International Patent Classification (IPC) or to both national classification and IPC

**B. FIELDS SEARCHED**

Minimum documentation searched (classification system followed by classification symbols)

H01L21/02; H01L21/56

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2021-111645 A (SHOWA DENKO MATERIALS CO., LTD.) 02 August 2021 (2021-08-02)<br>    paragraphs [0023]-[0131], fig. 1-5 | 1-10 |
| Y | JP 2018-9138 A (HITACHI CHEMICAL CO., LTD.) 18 January 2018 (2018-01-18)<br>    paragraphs [0026]-[0152], fig. 1-6 | 1-10 |
| Y | JP 2013-110352 A (JSR CORP.) 06 June 2013 (2013-06-06)<br>    paragraphs [0012]-[0117] | 1-10 |
| Y | WO 2020/138240 A1 (NISSAN CHEMICAL CORP.) 02 July 2020 (2020-07-02)<br>    paragraphs [0014]-[0177], fig. 1, 2 | 1-10 |
| Y | JP 2004-64040 A (3M INNOVATIVE PROPERTIES CO.) 26 February 2004 (2004-02-26)<br>    paragraphs [0010]-[0067], fig. 1-8 | 1-10 |
| Y | JP 2015-224316 A (DENKA CO., LTD.) 14 December 2015 (2015-12-14)<br>    paragraphs [0012]-[0058] | 1-10 |

☑ Further documents are listed in the continuation of Box C.       ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **01 November 2022** | **15 November 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**

| | International application No. |
| --- | --- |
| | **PCT/JP2022/032589** |

**C.     DOCUMENTS CONSIDERED TO BE RELEVANT**

| Category* | Citation of document, with indication, where appropriate, of the relevant passages | Relevant to claim No. |
| --- | --- | --- |
| Y | JP 2016-138182 A (DENKA CO., LTD.) 04 August 2016 (2016-08-04)<br>      paragraphs [0011]-[0052] | 1-10 |
| Y | US 2016/0284582 A1 (INTERNATIONAL BUSINESS MACHINES CORP.) 29 September 2016 (2016-09-29)<br>      paragraphs [0014]-[0075], fig. 1-4 | 1-10 |
| Y | JP 2016-174098 A (TOSHIBA CORP.) 29 September 2016 (2016-09-29)<br>      paragraphs [0008]-[0055], fig. 1-4 | 6 |
| A | JP 2020-514433 A (THREE M INNOVATIVE PROPERTIES CO.) 21 May 2020 (2020-05-21)<br>      entire text, all drawings | 1-10 |

Form PCT/ISA/210 (second sheet) (January 2015)

**INTERNATIONAL SEARCH REPORT**
Information on patent family members

International application No.

**PCT/JP2022/032589**

| Patent document cited in search report | | | Publication date (day/month/year) | Patent family member(s) | | Publication date (day/month/year) |
|---|---|---|---|---|---|---|
| JP | 2021-111645 | A | 02 August 2021 | (Family: none) | | |
| JP | 2018-9138 | A | 18 January 2018 | (Family: none) | | |
| JP | 2013-110352 | A | 06 June 2013 | (Family: none) | | |
| WO | 2020/138240 | A1 | 02 July 2020 | US 2022/0073801 A1 paragraphs [0023]-[0183], fig. 1, 2 | | |
| | | | | EP 3907074 | A1 | |
| | | | | CN 113226743 | A | |
| | | | | KR 10-2021-0107788 | A | |
| | | | | SG 11202107006X | A | |
| | | | | TW 202026387 | A | |
| JP | 2004-64040 | A | 26 February 2004 | US 2005/0233547 A1 paragraphs [0021]-[0114], fig. 1a-8 | | |
| | | | | WO 2004/006296 | A2 | |
| | | | | CN 1703773 | A | |
| | | | | TW 200402352 | A | |
| | | | | KR 10-2010-0121687 | A | |
| | | | | AU 2003278696 | A1 | |
| | | | | MY 141078 | A | |
| JP | 2015-224316 | A | 14 December 2015 | (Family: none) | | |
| JP | 2016-138182 | A | 04 August 2016 | (Family: none) | | |
| US | 2016/0284582 | A1 | 29 September 2016 | WO 2016/151485 | A1 | |
| JP | 2016-174098 | A | 29 September 2016 | US 2016/0276200 A1 paragraphs [0009]-[0071], fig. 1A-4B | | |
| | | | | CN 105990124 | A | |
| | | | | TW 201705192 | A | |
| JP | 2020-514433 | A | 21 May 2020 | US 2020/0010735 A1 entire text, all drawings | | |
| | | | | WO 2018/109711 | A1 | |
| | | | | KR 10-2018-0069322 | A | |
| | | | | TW 201835202 | A | |
| | | | | CN 110072959 | A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2020111193 A1